# FASCICULE DE BREVET EUROPEEN

(11) **EP 0 783 191 B1**
(45) Date de publication et mention de la délivrance du brevet: **29.03.2000**
(21) Numéro de dépôt: 96402817.9
(22) Date de dépôt: 19.12.1996
(51) Int. Cl.: H01S 5/02, H01S 5/10, C23C 14/28

(54) **Procédé et dispositif de préparation de faces de laser**
Verfahren und Vorrichtung zur Behandlung von Laserfacetten
Method and device for the preparation of laser facets

(30) Priorité: 22.12.1995 FR 9515397
(43) Date de publication de la demande: 09.07.1997
(73) Titulaire: ALCATEL, 75008 Paris (FR)
(72) Inventeur: Belouet, Christian, 92330 Sceaux (FR); Boccon-Gibod, Dominique, 75017 Paris (FR); Kerboeuf, Sylvaine, 94260 Fresnes (FR)
(74) Mandataire: Feray, Valérie

(56) Documents cités:
- EP-A- 0 416 190
- DE-A- 4 340 752
- US-A- 4 987 007
- PROCEEDINGS OF THE INTERNATIONAL SEMICONDUCTOR LASER CONFERENCE, MAUI, HAWAII, SEPT. 19 - 23, 1994, no. CONF. 14, 19 Septembre 1994, INSTITUTE OF ELECTRICAL AND ELECTRONICS ENGINEERS, page 155/156 XP000514859 LIM G ET AL: "Novel technique for fabricating non absorbing mirror laser"
- IBM TECHNICAL DISCLOSURE BULLETIN, vol. 33, no. 6A, 1 Novembre 1990, page 285 XP000107720 "Improved operating lifetime of lasers with dry-etched mirrors"
- PATENT ABSTRACTS OF JAPAN vol. 008, no. 209 (E-268), 22 Septembre 1984 & JP 59 094892 A (SANYO DENKI KK), 31 Mai 1984,
- PATENT ABSTRACTS OF JAPAN vol. 018, no. 128 (C-1174), 2 Mars 1994 & JP 05 311429 A (NEC CORP), 22 Novembre 1993,
- APPLIED PHYSICS LETTERS, vol. 48, no. 12, 24 Mars 1986, pages 748-750, XP002028236 T.YUASA ET AL.: "Dry-etched-cavity pair-groove-substrate GaAs/AlGaAs multiquantum well lasers"

## Description

La présente invention concerne la préparation des faces des lasers à base de composés III-V, et en particulier des lasers de pompe GaAs/GaAlAs à 0,98µm. C'est cet exemple qui sera explicité dans la suite, à titre indicatif et nullement limitatif.

Une limitation importante de la durée de vie des lasers GaAs/GaAlAs est due à la détérioration brutale et irréversible des faces. L'origine de ce phénomène est attribuée à un processus qui met en jeu une cascade d'événements et en particulier la recombinaison des porteurs sur les zones des faces comportant des défauts, la réduction de la largeur de bande interdite dans ces zones, consécutive à l'échauffement provoqué par la recombinaison des porteurs, et enfin l'absorption optique croissante du rayonnement émis par le laser, consécutive à la réduction de la largeur de bande. Ces phénomènes, qui contribuent à un échauffement accéléré des faces du laser, conduisent finalement à la destruction irréversible des faces du laser. Cette destruction a reçu, dans la terminologie anglaise, le nom de COD (Catastrophic Optical Damage).

Cette destruction a été observée et étudiée en détail notamment dans le document "Degradation Behavior of 0.98µm Strained Quantum Well In GaAs/AlGaAs Lasers Under High Power Operation" par Mitsuo Fukuda, Masanobu Okayasu, Jiro Temmyo et Jun-ichi-Nakano, IEEE, Journal of Quantum Electronics, Vol. 30 n°2, Février 1994, p. 471-476.

Un des problèmes posé est donc de minimiser la recombinaison des porteurs sur les faces du laser. Cette recombinaison est stimulée par la présence d'oxydes, qui se forment pendant ou après les étapes technologiques associées à la réalisation des faces.

Il a été proposé, en particulier dans le document EP-A-0 416 190, pour minimiser l'oxydation, de réaliser les faces du laser par clivage sous ultra-vide (de l'ordre de 10⁻¹² mbar) et de procéder au dépôt d'une couche de passivation.

La mise en oeuvre de cette technique nécessite un investissement important conduisant à des prix de fabrication élevés.

Un premier but de la présente invention est de réaliser un procédé de préparation des faces qui soit économique.

Il a été proposé de réaliser la couche de passivation par évaporation thermique de silicium. Cette technique d'évaporation a pour inconvénient de nécessiter une durée très élevée, par exemple de l'ordre d'une heure pour obtenir une couche de passivation de l'ordre de 5 à 10 angströms (1 angström = 10⁻¹⁰m). En outre, les atomes de silicium, dans cette technique, arrivent avec une faible énergie et s'accrochent mal. Enfin, dans cette technique, il est nécessaire de réaliser l'opération avec une pression partielle d'oxygène très faible pour éviter le dépôt d'oxygène en même temps que de silicium. Il a été calculé que si on souhaite obtenir un dépôt avec un seul atome d'oxygène pour 1000 atomes de silicium, il est nécessaire d'abaisser la pression partielle d'oxygène au-dessous de 10⁻¹² mbar, ce qui est prohibitif et ramène aux difficultés évoquées précédemment.

Un deuxième but de l'invention est de choisir un procédé de passivation qui permette un dépôt de matériau de passivation suffisamment rapide pour avoir une proportion d'oxygène suffisamment faible sans nécessiter l'obtention d'une pression partielle d'oxygène trop faible.

Il a été décrit, dans l'article "Novel technique for fabricating Non Absorbing Mirror Laser", par Gabgyu Lim, Jaeho Lee, Gueorugi Park et Taeil Tim, XIV IEE Semiconductor Laser Conference, 19-23 septembre 1994, l'emploi d'un laser excimère pour traiter les faces d'un laser venant d'être clivées par un recuit. Ce document ne mentionne pas les énergies de traitement des faces.

Un troisième but de la présente invention est de définir des conditions opératoires permettant d'obtenir les meilleurs résultats.

L'invention a pour objet un procédé de préparation de faces de laser à base de composés III-IV, caractérisé en ce qu'il comprend les opérations suivantes:
1. on ouvre les faces du laser,
2. on soumet lesdites faces du laser, placées dans une enceinte où règne une pression de l'ordre de 10⁻⁷ à 10⁻⁸ mbar, à une phase de décapage par irradiation par un laser pulsé,
3. on soumet lesdites faces, à l'aide du même laser pulsé à une opération de passivation par un dépôt de silicium Si ou de nitrure de gallium GaN par la méthode dite d'ablation laser, jusqu'à obtention d'une épaisseur comprise entre 2 et 20 angströms.

Avantageusement, l'opération 2 est effectuée dans la même enceinte que l'opération 1.

Lorsque le dépôt est du nitrure de gallium, ce dépôt s'effectue par ablation laser d'une cible de gallium liquide dans une atmosphère d'azote avec création d'un plasma ECR.

Selon une autre caractéristique de l'invention, on soumet lesdites faces à un dépôt supplémentaire d'un film transparent à la longueur d'onde du laser à traiter et étanche à l'oxygène, tel que le carbone DLC, le carbure de silicium SiC ou le nitrure de silicium Si3N4, réalisé avec le même laser pulsé fonctionnant sous une fluence de 1 à 5 J/cm², jusqu'à obtention d'une épaisseur de quelques dizaines d'angströms.

Avantageusement, ledit dépôt supplémentaire est effectué dans la même enceinte que celle de l'opération de décapage.

Dans un mode particulier de mise en oeuvre du procédé, le laser pulsé est un laser à excimère fonctionnant avec des impulsions de durée comprise entre 10 et 30 nanosecondes à une cadence comprise entre 10 et 100Hz.

En variante, le laser pulsé est un laser YAG dopé au néodyme fonctionnant avec des impulsions de durée comprise entre 4 et 6 nanosecondes à une cadence comprise entre 10 et 100Hz.

Lorsque le laser traité est un laser de pompe GaAs/GAAsAl à 0,98µm, la fluence du laser, lors de l'opération de décapage, est comprise entre 70 et 120 mJ/cm².

La fluence du laser, lors de l'opération de passivation, est alors comprise entre 1 et 5 J/cm².

Selon une autre caractéristique de l'invention, il est procédé, avant la phase de passivation, à une phase supplémentaire de décapage réalisé sous atmosphère de chlore ou de brome, à l'aide d'un laser excimère pulsé.

Lorsque l'atmosphère est une atmosphère de chlore, la pression est de l'ordre de 10⁻⁵ mbar.

La fluence du laser est alors de l'ordre de 80mJ/cm².

L'invention a également pour objet un dispositif pour la mise en oeuvre du procédé , caractérisé en ce qu'il comprend:
- une enceinte dans laquelle est maintenue une pression comprise entre 10⁻⁷ et 10⁻⁸ mbar et contenant notamment un support pour barreau laser dans lequel des faces de laser ont été taillées et sont à traiter, un moyen pour permettre le pivotement du support, au moins un support de cible pour traitement par la technique d'ablation laser, ladite enceinte comportant au moins une fenêtre optique pour le passage d'un rayon laser,
- et, à l'extérieur de ladite enceinte, un laser muni de moyens de réglage de sa fluence, de sa cadence de tir et d'orientation de son faisceau sur les faces du laser à traiter ou sur la cible.

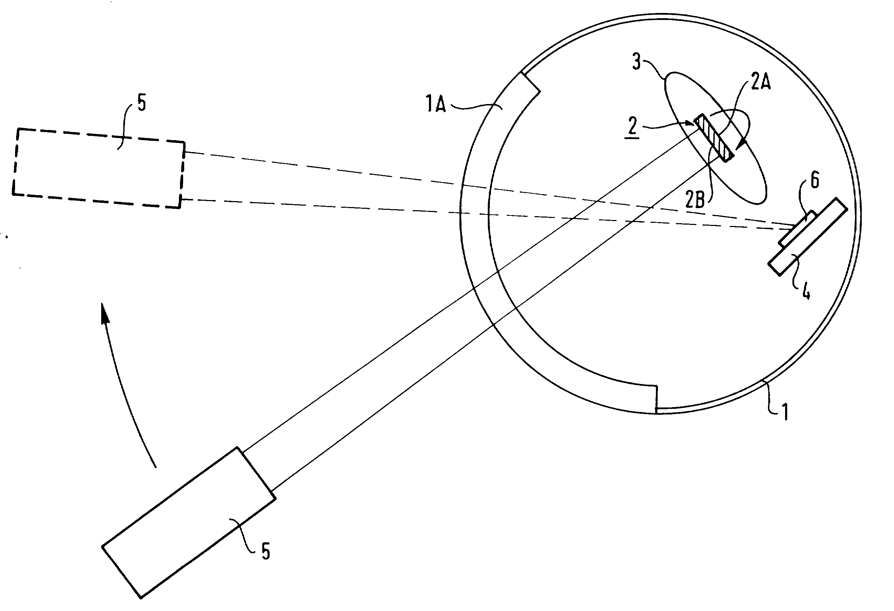

Le procédé est décrit en regard du dessin ci-joint représentant schématiquement l'appareillage pour sa mise en oeuvre.

Selon l'invention, les barreaux du laser dont les faces sont à traiter sont introduites dans une enceinte 1.

Les faces ont été préalablement ouvertes dans le barreau laser GaAs/GaAlAs à 0,98µm, par exemple par clivage sous atmosphère contrôlée (non oxydante, par exemple azote), ou par une technique collective chimique ou mécanique. En général, on traite un barreau comportant par exemple de 15 à 25 lasers comprenant chacun des premières et des secondes faces. Les premières faces sont traitées simultanément, puis c'est le tour des secondes faces.

Le barreau à traiter, référencé 2 dans la figure, est placé sur un support 3. Les faces 2A et 2B des lasers sont traitées successivement, et pour cela, le support 3 est muni de moyens non représentés permettant de le faire pivoter selon les angles souhaités lors du déroulement du procédé. Ces moyens sont simplement symbolisés dans la figure par la flèche courbe.

L'enceinte est munie de moyens pour y créer le vide et maintenir un vide résiduel de l'ordre de 10⁻⁷ à 10⁻⁸ mbar par exemple.

L'enceinte comprend au moins un autre support fixe 4 permettant de placer une cible destinée à réaliser une opération d'ablation laser.

Au moins une partie de l'enceinte est réalisée en un matériau transparent au rayonnement d'un laser extérieur; cette portion est référencée 1A dans la figure.

A l'extérieur de l'enceinte est disposé un laser 5 servant au procédé de traitement de l'invention; il est équipé de moyens de réglage de sa fluence, de sa cadence de tir et de son orientation pour que son faisceau atteigne soit les faces du laser à traiter, soit la cible pour l'ablation laser.

Le procédé de l'invention est le suivant: le laser à traiter étant placé sur son support, on irradie ses faces par le rayonnement du laser pulsé, de manière à décaper la ou les couches d'oxyde sur ses faces, et éliminer tout contaminant éventuellement adsorbé.

Le laser pulsé est par exemple du type à excimère fonctionnant aux longueurs d'onde de 356, 308, 248 ou 193 nanomètres.

La durée des impulsions est alors de l'ordre de 30 nanosecondes.

En variante, le laser pulsé est de type YAG quadruplé dopé au néodyme et permetant d'obtenir une longueur d'onde de 266 nanomètres; dans ce cas la durée des impulsions est comprise entre 4 et 6 nanosecondes.

Dans les deux cas, selon l'invention, le domaine de fluence du laser est compris entre 70 et 120 mJ/cm².

Le nombre de tirs, qui dépend du laser utilisé et de la fluence choisie, sera compris entre 1000 et 20.000 avec une cadence comprise entre 10 et 100Hz.

On notera que plusieurs barreaux laser peuvent être traités simultanément, selon la largeur du faisceau laser.

La deuxième phase du procédé consiste à déposer sur les faces décapées un matériau de passivation. Le matériau de passivation est de préférence le silicium, mais on peut utiliser aussi le nitrure de gallium GaN.

Avantageusement, ce dépôt de passivation est effectué dans la même enceinte que celle qui a servi au décapage. De la sorte, aucune manipulation n'est nécessaire, ce qui contribue à réduire le coût de traitement.

Selon l'invention, le dépôt de la couche de passivation est réalisé au moyen de la méthode dite d'ablation laser (en anglais PLD pour pulsed laser deposition).

Selon le procédé de l'invention, on utilise le même laser 5 que pour le décapage; le laser à traiter 2 est orienté convenablement en face de la cible 4.

Pour une passivation au silicium, on dépose sur la cible une pastille 6 de silicium. Le laser de traitement 5 est orienté pour viser la cible et sa fluence et sa cadence de tir sont ajustées.

Les conditions de fluence sont cette fois de 1 à 5 J/cm². Il suffit de quelques tirs pour obtenir un dépôt d'épaisseur comprise entre 2 et 20 angströms.

On note que lorsque le matériau déposé est du silicium, en raison de la brièveté du traitement, il ne parvient que très peu d'atomes d'oxygène sur les faces à traiter bien que la pression partielle d'oxygène dans l'enceinte soit relativement élevée (entre 10⁻⁸ et 10⁻¹⁰ mbar).

Lorsque le matériau déposé est du nitrure de gallium, le dépôt est réalisé de préférence en plaçant sur la cible du gallium liquide et en soumettant l'enceinte à une atmosphère d'azote avec une pression partielle d'azote de 10⁻³ à 10⁻¹ mbar; de préférence un plasma ECR est créé dans la zone de dépôt pour générer de l'azote atomique qui s'incorpore plus facilement dans le film de passivation.

Le traitement est terminé par une opération consistant à déposer sur les faces ayant reçu le traitement de passivation qui vient d'être décrit, une épaisseur de quelques dizaines d'angströms d'un matériau transparent à la longueur d'onde de 0,98µm et étanche à l'oxygène, tel que le carbone DLC, le carbure de silicium SiC ou le nitrure de silicium Si₃N₄.

Cette opération est impérative lorsque la couche de passivation est du silicium; elle est facultative lorsque le dépôt de passivation est du nitrure de gallium GaN.

On utilise pour cela la méthode d'ablation laser; pour le dépôt de carbone DLC, on placera sur le support 4 une cible de carbone pyrolitique; pour le dépôt de carbure de silicium, on placera sur le support 4 une cible de carbure de silicium; pour le dépôt de nitrure de silicium, on placera sur le support 4 une cible de silicium et on fera régner dans l'enceinte 1 une atmosphère d'azote sous faible pression, avec création d'un plasma ECR favorisant l'incorporation de l'azote grâce à la présence d'azote atomique.

On règlera convenablement le laser 5 et on ajustera sa fluence entre 1 et 5 J/cm². Quelques minutes suffisent pour obtenir l'épaisseur désirée qui est de quelques dizaines d'angströms.

Là encore le traitement est de préférence effectué dans la même enceinte que précédemment.

Il a été observé que le décapage des faces par laser peut conduire à dégrader l'état de surface de la facette, en raison notamment de l'émission, pendant l'irradiation par laser, de composés à base d'arsenic. Selon un mode préféré de réalisation de l'invention, il est prévu, avant l'étape de passivation, de réaliser une phase de reconstruction de surface, par un décapage des faces GaAs/GaAlAs au moyen de chlore ou de brome avec l'assistance d'un laser UV. Le rôle de l'irradiation par laser UV est de provoquer la désorption chimique des produits de chloruration (par exemple GaCl₃,AlCl_{X}) qui se forment entre les impulsions laser. Par exemple, les faces sont irradiées par un laser UV pulsé sous une pression de chlore comprise entre 10⁻⁵ et 10⁻¹ mbar. La fluence du laser est comprise entre 5.10⁵ et 5.10⁶ W/cm². Ce procédé rend la surface lisse comme un miroir, avec une composition stoechiométrique; elle est alors prête pour la phase de passivation.

Les facettes des lasers GaAs/GaAlAs sont constituées d'au moins 99% de AlGaAs. C'est pourquoi la phase précitée vise à décaper l'AlGaAs, dont le taux de décapage est plus élevé que celui de GaAs.

A titre d'exemple, le laser peut être un laser excimère KrF (248 nm). La pression de chlore est de 10⁻⁵ mbar. L'échantillon est irradié sous une fluence laser d'environ 80mJ/cm² (3.10⁶W/cm²), avec une fréquence de 10Hz. Dans ces conditions, la phase dure à peu près une minute.

Grâce au procédé de l'invention, la durée de fonctionnement des lasers de pompe a été augmentée de manière sensible. Le procédé peut être facilement industrialisé pour conduire, pour les lasers de pompe à des prix de revient fortement abaissés.

L'invention n'est pas limitée à l'exemple décrit en détail mais s'applique à tous les lasers à base de composés III-IV. L'homme du métier saura, grâce à l'enseignement du présent mémoire, ajuster les paramètres caractéristiques.

## Revendications

1. Procédé de préparation de faces de laser à base de composés III-IV, caractérisé en ce qu'il comprend les opérations suivantes:
- a. on ouvre les faces du laser,
- b. on soumet lesdites faces du laser, placées dans une enceinte où règne une pression de l'ordre de 10⁻⁷ à 10⁻⁸ mbar, à une phase de décapage par irradiation par un laser pulsé,
- c. on soumet lesdites faces décapées, à l'aide du même laser pulsé à une opération de passivation par un dépôt de silicium Si ou de nitrure de gallium GaN par la méthode dite d'ablation laser, jusqu'à obtention d'une épaisseur comprise entre 2 et 20 angströms (1 angström = 10⁻¹⁰ m).

2. Procédé selon la revendication 1, caractérisé en ce l'opération 2 est effectuée dans la même enceinte que l'opération 1.

3. Procédé selon l'une des revendications 1 et 2, caractérisé en ce que, lorsque le dépôt est du nitrure de gallium, ce dépôt s'effectue par ablation laser d'une cible de gallium liquide dans une atmosphère d'azote avec création d'un plasma ECR.

4. Procédé selon l'une des revendications 1 à 3, caractérisé en ce qu'on soumet lesdites faces à un dépôt supplémentaire, par la méthode dite d'ablation laser, d'un film transparent à la longueur d'onde du laser à traiter et étanche à l'oxygène, tel que le carbone DLC, le carbure de silicium SiC ou le nitrure de silicium Si3N4, réalisé avec le même laser pulsé fonctionnant sous une fluence de 1 à 5 J/cm², jusqu'à obtention d'une épaisseur de quelques dizaines d'angströms.

5. Procédé selon la revendication 4, caractérisé en ce que ledit dépôt supplémentaire est effectué dans la même enceinte que celle de l'opération de décapage.

6. Procédé selon l'une des revendications 1 à 5, caractérisé en ce que le laser pulsé est un laser à excimère fonctionnant avec des impulsions de durée comprise entre 10 et 30 nanosecondes à une cadence comprise entre 10 et 100Hz.

7. Procédé selon l'une des revendications 1 à 5, caractérisé en ce que laser pulsé est un laser YAG dopé au néodyme fonctionnant avec des impulsions de durée comprise entre 4 et 6 nanosecondes à une cadence comprise entre 10 et 100Hz.

8. Procédé de préparation de faces de laser selon l'une des revendications 1 à 7, caractérisé en ce que, lorsque le laser traité est un laser de pompe de GaAs/GAAsAl à 0,98µm, la fluence du laser, lors de l'opération de décapage, est comprise entre 70 et 120 mJ/cm².

9. Procédé selon la revendication 8, caractérisé en ce que la fluence du laser, lors de l'opération de passivation, est comprise entre 1 et 5 J/cm².

10. Procédé selon l'une des revendications 1 à 9, caractérisé en ce qu'il est procédé, avant la phase de passivation, à une phase supplémentaire de décapage réalisé sous atmosphère de chlore ou de brome, à l'aide d'un laser excimère pulsé.

11. Procédé selon la revendication 10, caractérisé en ce que l'atmosphère est une atmosphère de chlore sous une pression de l'ordre de 10⁻⁵ mbar.

12. Procédé selon l'une des revendications 10 et 11, caractérisé en ce que la fluence du laser est de l'ordre de 80mJ/cm².

13. Dispositif pour la mise en oeuvre du procédé selon les revendications précédentes, caractérisé en ce qu'il comprend:
- une enceinte (1) dans laquelle est maintenue une pression comprise entre 10⁻⁷ et 10⁻⁸ mbar et contenant notamment un support (3) pour barreau laser (2) dans lequel des faces de laser (2A, 2B) ont été taillées et sont à traiter, un moyen pour permettre le pivotement du support, au moins un support (4) de cible pour traitement par la technique d'ablation laser, ladite enceinte comportant au moins une fenêtre optique (1A) pour le passage d'un rayon laser,
- et, à l'extérieur de ladite enceinte, un laser (5) muni de moyens de réglage de sa fluence, de sa cadence de tir et d'orientation de son faisceau sur les faces du laser à traiter ou sur la cible.

## Patentansprüche

1. Verfahren zum Bearbeiten der Facetten von Lasern auf Grundlage von III-V-Verbindungen, dadurch gekennzeichnet, daß es die folgenden Schritte umfaßt:
a. die Facetten des Lasers werden freigelegt,
b. diese Facetten werden, plaziert in einem Behälter, in dem ein Druck in der Größenordnung von 10⁻⁷ bis 10⁻⁸ mbar herrscht, einer Beizphase durch Bestrahlen mit einem gepulsten Laser unterzogen,
c. die gebeizten Facetten werden mit Hilfe des gleichen gepulsten Lasers einer Operation der Passivierung durch eine Abscheidung von Silicium Si oder Galliumnitrid GaN durch das sogenannte Laserablationsverfahren unterzogen, bis eine Dicke zwischen 2 und 20 Angström (1 Angström = 10⁻¹⁰ m) erhalten wird.

2. Verfahren nach Anspruch 1, dadurch gekennzeichnet, daß die Operation 2 in dem gleichen Behälter ausgeführt wird wie die Operation 1.

3. Verfahren nach Anspruch 1 oder 2, dadurch gekennzeichnet, daß, wenn die Abscheidung Galliumnitrid ist, die Abscheidung durch Laserablation eines flüssigen Galliumtargets in einer Stickstoffatmosphäre unter Erzeugung eines ECR-Plasmas erfolgt.

4. Verfahren nach einem der Ansprüche 1 bis 3, dadurch gekennzeichnet, daß die Facetten der zusätzlichen Abscheidung durch das Laserablationsverfahren eines bei der Wellenlänge des zu bearbeitenden Lasers transparenten und sauerstoffundurchlässigen Films wie etwa DLC-Kohlenstoff, Siliciumcarbid SiC oder Siliciumnitrid Si₃N₄ unterzogen werden, die mit dem gleichen gepulsten Laser, arbeitend bei einer Fluenz von 1 bis 5 J/cm², durchgeführt wird, bis eine Dicke von einigen Zehn Angström erhalten wird.

5. Verfahren nach Anspruch 4, dadurch gekennzeichnet, daß diese zusätzliche Abscheidung in dem gleichen Behälter wie die Beizoperation durchgeführt wird.

6. Verfahren nach einem der Ansprüche 1 bis 5, dadurch gekennzeichnet, daß der gepulste Laser ein Excimerlaser ist, der mit Impulsen von zwischen 10 und 30 ns Dauer und einer Wiederholrate zwischen 10 und 100 Hz arbeitet.

7. Verfahren nach einem der Ansprüche 1 bis 5 dadurch gekennzeichnet, daß der Laser ein Nd-dotierter YAG-Laser ist, der mit Impulsen von zwischen 4 und 6 ns Dauer und einer Wiederholrate zwischen'10 und 100 Hz arbeitet.

8. Verfahren zum Bearbeiten der Facetten von Lasern nach einem der Ansprüche 1 bis 7, dadurch gekennzeichnet, daß wenn der bearbeitete Laser ein GaAs/GaAsAl-Pumplaser bei 0,98 µm ist, die Fluenz des Lasers bei der Beizoperation zwischen 70 und 120 mJ/cm² liegt.

9. Verfahren nach Anspruch 8, dadurch gekennzeichnet, daß die Fluenz des Lasers bei der Passivierungsoperation zwischen 1 und 5 J/cm² liegt.

10. Verfahren nach einem der Ansprüche 1 bis 9, dadurch gekennzeichnet, daß vor der Passivierungsphase eine zusätzliche Beizphase, die unter Chlor- oder Bromatmosphäre abläuft, mit Hilfe eines gepulsten Excimerlasers durchgeführt wird.

11. Verfahren nach Anspruch 10, dadurch gekennzeichnet, daß die Atmosphäre eine Chloratmosphäre unter einem Druck in der Größenordnung von 10⁻⁵ mbar ist.

12. Verfahren nach einem der Ansprüche 10 und 11, dadurch gekennzeichnet, daß die Fluenz des Lasers in der Größenordnung von 80 mJ/cm² liegt.

13. Vorrichtung zur Durchführung des Verfahrens nach den vorhergehenden Ansprüchen, dadurch gekennzeichnet, daß sie umfaßt:
- einen Behälter (1), in dem ein Druck zwischen 10⁻⁷ und 10⁻⁸ mbar aufrechterhalten wird und der insbesondere einen Träger (3) für einen Laserstab (2), in den Laserfacetten (2A, 2B) geschnitten worden sind und zu bearbeiten sind, ein Mittel zum Ermöglichen des Schwenkens des Trägers, wenigstens einen Targetträger (4) für die Bearbeitung durch die Laserablationstechnik umfaßt, wobei der Behälter wenigstens ein optisches Fenster (1A) für den Durchgang eines Laserstrahls aufweist,
- und außerhalb des Behälters einen Laser (5), der mit Mitteln zum Regeln seiner Fluenz, seiner Schußwiederholrate und zum Orientieren seines Strahls auf die Facetten des zu bearbeitenden Lasers oder auf das Target ausgestattet ist.

## Claims

1. A method of preparing faces of a laser based on III-IV compounds, the method being characterized in that it comprises the following operations:
a) the faces of the laser are opened;
b) said faces of the laser are placed in an enclosure in which there obtains a pressure of about 10⁻⁷ mbar to about 10⁻⁸ mbar, and they are subjected to a step of cleaning by irradiation with a pulsed laser; and
c) the same pulsed laser is used to ablate a target so as to subject said cleaned faces to a passivation operation whereby silicon Si or gallium nitride GaN is deposited thereon by the pulsed laser deposition (PLD) method until a thickness is obtained lying in the range 2 Å to 20 Å (1 Å = 10⁻¹⁰ m).

2. A method according to claim 1, characterized in that operation 2) is performed in the same enclosure as operation 1).

3. A method according to claim 1 or 2, characterized in that when the deposit is of gallium arsenide, said deposition is performed by pulsed laser ablation of a liquid gallium target in a nitrogen atmosphere with an ECR plasma being created.

4. A method according to any one of claims 1 to 3, characterized in that said faces are subjected to additional deposition, by the laser ablation method, of a film that is transparent at the wavelength of the laser to be treated and that is proof against oxygen, such as DLC carbon, silicon carbide SiC, or silicon nitride Si₃N₄, made using the same pulsed laser operating at a fluence of 1 J/cm² to 5 J/cm² until a thickness of several tens of Å have been obtained.

5. A method according to claim 4, characterized in that said additional deposition is performed in the same enclosure as the cleaning operation.

6. A method according to any one of claims 1 to 5, characterized in that the pulsed laser is an excimer laser operating with pulses of duration lying in the range 10 ns to 30 ns at a rate lying in the range 10 Hz to 100 Hz.

7. A method according to any one of claims 1 to 5, characterized in that the pulsed laser is a neodymium-doped YAG laser operating with pulses of duration lying in the range 4 ns to 6 ns at a rate lying in the range 10 Hz to 100 Hz.

8. A method of preparing laser faces according to any one of claims 1 to 7, characterized in that, when the treated laser is a GaAs/GaAsAl laser for pumping at 0.98 µm, the laser fluence during the cleaning operation lies in the range 70 mJ/cm² to 120 mJ/cm².

9. A method according to claim 8, characterized in that the laser fluence during the passivation operation lies in the range 1 J/cm² to 5 J/cm².

10. A method according to any one of claims 1 to 9, characterized in that, prior to the passivation stage, an additional cleaning stage is performed under an atmosphere of chlorine or of bromine, using a pulsed excimer laser.

11. A method according to claim 10, characterized in that the atmosphere is an atmosphere of chlorine under a pressure of about 10⁻⁵ mbar.

12. A method according to claim 10 or 11, characterized in that the fluence of the laser is about 80 mJ/cm².

13. Apparatus for implementing the method according to any preceding claim, characterized in that it comprises:
· an enclosure (1) in which a pressure lying in the range 10⁻⁷ mbar to 10⁻⁸ mbar is maintained and containing, in particular, a support (3) for a laser rod (2) in which laser faces (2A, 2B) have been cut and are to be treated, means for enabling the support to pivot, at least one support (4) for a target for treatment by the laser ablation technique, with said enclosure further including at least one optical window (1A) for passing a laser beam; and
· outside said enclosure, a laser (5) provided with means for adjusting its fluence, its firing rate, and the direction of its beam to strike the faces of the laser to be treated or the target.
